# EUROPEAN PATENT APPLICATION

(11) **EP 1 073 098 A1**
(43) Date of publication of application: **31.01.2001**
(21) Application number: 99114787.7
(22) Date of filing: 28.07.1999
(51) Int. Cl.: H01L 21/00

(54) **Low stress wafer mounting assembly and method**

(71) Applicant: Infineon Technologies AG, 81541 München (DE)
(72) Inventor: Schneegans, Manfred, Dr., 85591 Vaterstetten (DE); Hinz, Christine, 01109 Dresden (DE); Mimietz, Steffen, 01279 Dresden (DE)
(74) Representative: Fischer, Volker, Dipl.-Ing.

(57) **Abstract**

The present invention is concerned with adhesive mounting a wafer on a tape and separating or dividing the wafer after backside grinding. According the invention the tape consists of a support tape (1) and precut tapes (2) which are adhered at the support tape (1). The precut tape (2) is fixed at a frame (5) without any stress or bi-directional expanding. The wafer (3) is backside adhered on the top side of the precut tape (2).

## Description

### FIELD OF THE INVENTION

The present invention relates to a low stress wafer mounting assembly and a method for producing semiconductor devices after finalizing the device by frontend processing. More particularly, the present invention is concerned with adhesive mounting a wafer on a tape and separating or dividing the wafer after backside grinding and braking or dicing into dice.

### DESCRIPTION OF THE PRIOR ART

Within the standard technique which is usable until wafer sizes of 200 mm a dicing tape is used on which the wafer is to be mounted by way of an adhesive. This dicing tape is fixed at the surface of a frame with a round circumference. Preferably stainless steel is used as frame material so that it is rigid enough against bending or twisting. The diameter of this frame must be greater than that of the wafer so that a collar surrounds the wafer.

The dicing tape which is stored on a roll of about 100 to 200 m length must first pulled to the mounting station. Then the tape is fixed with expansion clamps or similar means so that the tape can expanded to perpendicular x- and y-axis. After the expanding process the tape is mounted on the frame. The wafer is than mounted on the top of the dicing tape and the tape will be cut circular around the frame. The circular cut is taken out with a heated knife or a blade.

The tape lamination on the frame and circular cutting of the tape creates wrinkles and warpage especially of the frames, because of non uniformity of bi-directional tape expansions during roll off in the tape lamination unit and decreasing blade conditions in the cutting unit of the mounting equipment.

To produce a semiconductor device after finalizing the device by frontend processing it is necessary to divide the wafer into dice. The standard process therefore is fixing the wafer on a vacuum wafer table on which are scribed cut lines defining dice. This step is carried out with a dicing apparatus by cutting with a blade through the wafer. Then the expandable sheet is fixed by means of an expandable ring at this state and is delivered to a subsequent die bonding process.

To improve the described process discloses the US 5,332,406 an apparatus for producing semiconductor device. The described method allows the wafer to be semi-fully or fully cut, thus improving the product quality and shortening the production time. To carry out this steps the wafer is first adhered to an ultraviolet sensitive adhesive tape which loses its adhesivity when irradiated by ultraviolet rays. This tape is adhered to a ring frame together with the adhered wafer. The following cutting or braking process is the same as above described.

A dicing section, a breaking section and an ultraviolet irradiation section are arranged in series on the downstream side of a wafer mounting section. An unloader section for unloading the wafer after the processing is disposed on the downstream side of the ultraviolet irradiation section. This ultraviolet irradiation section reduces the adhesive force of the diced wafer on the tape so that the dices can be transfered to a die bonding machine more easier.

### SUMMARY OF THE INVENTION

It is an object of the present invention to provide a low stress wafer mounting assembly and method after backside grinding which is applicable for all wafer sizes, such as 300 mm wafers.

Another object of the present invention is to improve the process of the wafer frame mounting process.

A further object of the present invention is the introduction of plastic frames even to 300 mm wafers to save weight during overseas transportation to assembly lines

In accordance with one object of the invention there is provided a low stress wafer mounting assembly for producing semiconductor devices after finalizing the device by frontend processing comprising a support tape as a continuous transportation base film with a greater length, a circularly precut tape material which is adhered on the support tape, a circular frame on which the precut tape material is fixed by clamps or other mounting elements whereby the support tape is removed from the precut tape material, and a ground wafer backside adhered on the top side of the precut tape material.

Preferably the support tape is a non expandable material so that it is possible to transport and fix the precut tape without any stress on the frame.

Further the precut material has a diameter greater than that of the wafer so that the collar surrounding the wafer can be fixed on the frame and the support tape is provided with a layer of an adhesive for adhering the precut tape.

The precut tape is of an UV- or a Non-UV-type.

Since the precut tape is fixed on the frame without any stress or bi-directional expansion are wrinkles and frame warpage prevented and the frame can consist of an organo-plastic-compound.

The support tape is preferably stored at a roll at which the precut tapes are pre-mounted.

In accordance with another aspect of the invention there is provided a low stress wafer mounting method for producing semiconductor devices after finalizing the device by frontend processing comprising the steps of providing precut tapes with a disk-like shape which have an adhesive layer at one side of it and which are adhered on a support tape with a given distance to each other, fixing the wafer face down on a chuck table so that the ground backside of the wafer is above, face down positioning the frame centrically surrounding the wafer on the chuck table and fixing the frame at this position, supply the support tape to the chuck table over the backside of the wafer and of the frame, loosen a front part of the precut tape from the support tape at the front end seen into transportation direction and turning the front part about 180E, adhering the front part at the frame, transportation of the support tape into transportation direction thereby laminating the precut tape on the whole surface of the frame and the wafer simultaneous by complete take off the precut tape from the support tape, and transportation the frame with the mounted wafer to assembly lines.

The precut tapes are provided from a cutting tool with a diameter greater than that of the ground wafer and smaller than the diameter of the frame.

The new technique is applicable for all wafer sizes and the utilization of precut tape prevents any scratches and damage to the frame surface in the mounting equipment because no knife- or blade-cutting unit is needed. Light frames of new size-design and new developed organo-plastic compounds are evaluated and fit to 300 mm mounting tools.

After Die Sorting or Die Bonding the precut tape removal from frames can be perform manually or automatically. After surface cleaning the frame is recycled and ready for next application. The new Wafer Frame Mounting results in a high potential of process and reliability improvement and weight saving for cargo transportation.

### BRIEF DESCRIPTION OF THE DRAWINGS

- Fig. 1: illustrates schematic a support tape with some adhered precut tape materials,
- Fig. 2: is a side view at the support tape according Fig. 1,
- Fig. 3: shows the frame with the fixed precut material, the support tape is removed and a ground wafer adhered at the top side of the precut material, and
- Fig. 4: shows a top view at the frame according Fig. 3.

### DETAILED DESCRIPTION OF THE INVENTION

The mounting assembly and the mounting method according invention will now be described in detail with reference to the accompanying drawings.

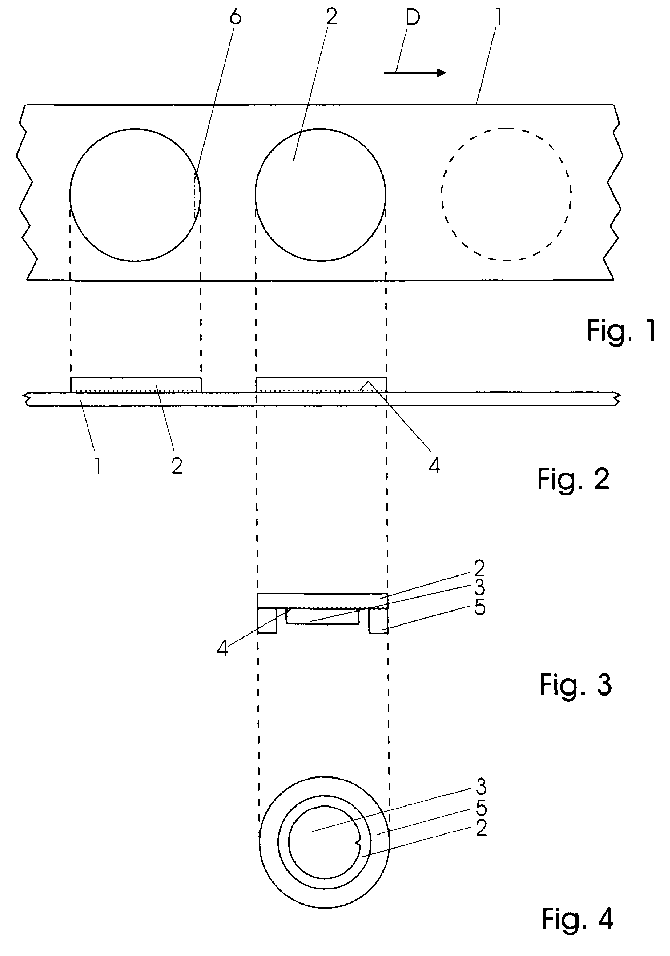

As schematically shown at Fig.1 and 2 the mounting assembly consists of a support tape 1 as a continuous transportation base film with a greater length so that the support tape 1 can be stored at a not shown roll. The support tape 1 is a base for adhering a precut tape material 2.

As shown in Fig. 1 and 2 the precut tape material 2 has a circularly circumference. The diameter of the disc-shaped precut tape material 2 must be greater than that of a ground wafer 3 backside adhered at the precut tape 2 at a later step (Fig. 3). The precut tape is provided with a layer of an adhesive 4 and is of an UV- or a Non-UV-type as commercially available.

The support tape 1 consists preferably of an non-expandable material. The adhesive 4 on the support tape 2 is used for fixing it at the support tape 1. As shown in Fig 1 the precut tapes 2 are placed at the support tape 1 at such a manner that the particular precut tapes are separated from each other.

After this a ring-shaped frame 5 and the wafer 3 are fixed face down on a chuck table (not shown) at such a manner that the frame 5 surrounds the wafer 3 centrical and the precut tape 2 can be fixed on the ring-shaped frame 5 and the wafer simultaneous as described later.

Not any stressing or expanding of either the support tape 1 or the precut tape 2 is neccesary at this steps what prevents wrinkles and frame warpage. Therfore it is possible to use plastic frames 5 made of an organo-plastic or a similar light material. The new frames 5 are of light weight, about three times less than stainless steel.

Figs. 3 and 4 showing the mounting assembly after the precut tape 2 is removed from the support tape 1 and with the ground wafer 3 backside adhered on the precut tape 2 within the frame 5. Utilization of the precut tape 2 prevents any scratches and damages to the frame surfaces in a not shown mounting equipment because no knife- or blade-cutting unit is needed.

The precut tape 2 can pulled off from the support tape 1 very easy and without any stretching and also without any utilization of a knife.

The mounting procedure encloses the steps of providing a support tape 1 with precut tapes 2 adhered at the upper side of the support tape 1. This precut tapes 2 have a disk-like shape and are provided with an adhesive layer 4 to adhere on the support tape 1 with a given distance to each other.

At the next step the wafer 3 is fixed face down on a chuck table (not shown) with the ground backside on the top. Then the frame 5 is face down positioned at the surface of the chuck so that the frame 5 surrounds the wafer 3 centrical and chucking the frame 5 at this position.

Now the support tape 1 can be supplied to the chuck table over the backside of the wafer 3 and the frame 5. Supply of the support tape 1 is performed so that a small front part 6 of the precut tape 2 is positioned adjacent a respective part of the frame 5.

At the next step the small front part 6 of the precut tape 2 is loosened from the support tape 1. As the front part 6 is to understand a part of the precut tape 2 at the front end seen into transportation direction D. Then the front part 6 is turned about 180E and adhered with the adhesive 4 at the respective part of the frame 5.

The final step is transportation the support tape 1 into transportation direction D thereby laminating the remaining precut tape 2 on the whole surface of the frame 5 and of the wafer 3 simultaneous by complete take off the precut tape 2 from the support tape 1.

The frame 5 with the mounted wafer 3 is now free for transportation, i.e. cargo overseas transportation, to assembly lines. After Die Sorting or Die Bonding the precut tape removal from the frames can be performed manually or automatically and after surface cleaning the frame 5 is recycled and ready for next application.

## Claims

1. A low stress wafer mounting assembly for producing semiconductor devices after finalizing the device by frontend processing comprising:
a) a support tape (1) as a continuous transportation base film with a greater length,
b) a circularly precut tape material (2) which is adhered on the support tape (1),
c) a circular frame (5) on which the precut tape material (2) is fixed by clamps or other mounting elements whereby the support tape (1) is removed from the precut tape material (2), and
d) a ground wafer (3) backside adhered on the top side of the precut tape material (2).

2. A low stress wafer mounting assembly according claim 1 wherein the support tape (1) is a non expandable material.

3. A low stress wafer mounting assembly according claim 1 or claim 2 wherein the precut material (2) has a diameter greater than that of the wafer (3).

4. A low stress wafer mounting assembly according one of the claims 1 to 3 wherein the support tape (1) is provided with a layer of an adhesive (4) for adhering the precut tape (2).

5. A low stress wafer mounting assembly according one of the claims 1 to 4 wherein the precut tape (2) is of an UV-type.

6. A low stress wafer mounting assembly according one of the claims 1 to 4 wherein the precut tape (2) is of an Non-UV-type.

7. A low stress wafer mounting assembly according one of the claims 1 to 6 wherein the frame (5) consists of an organo-plastic-compound.

8. A low stress wafer mounting assembly according one of the claims 1 to 7 wherein the source for the support tape (1) is a roll at which the precut tapes (2) are pre-mounted.

9. A low stress wafer mounting method for producing semiconductor devices after finalizing the device by frontend processing comprising the steps:
a) providing precut tapes (2) with a disk-like shape which have an adhesive layer at one side of it and which are adhered on a support tape (1) with a given distance to each other,
b) fixing the wafer (3) face down on a chuck table so that the ground backside of the wafer is above,
c) face down positioning the frame (5) centrically surrounding the wafer (3) on the chuck table and fixing the frame (5) at this position,
d) supply the support tape (1) to the chuck table over the backside of the wafer (3) and the frame (5),
e) loosen a front part (6) of the precut tape (2) from the support tape (1) at the front end seen into transportation direction and turning the front part (6) about 180E,
f) adhering the front part (6) at the frame (5),
g) transportation of the support tape (1) into transportation direction thereby laminating the precut tape (2) on the whole surface of the frame (5) and the wafer (3) simultaneous by complete take off the precut tape (2) from the support tape (1), and
h) transportation the frame (5) with the mounted wafer (3) to assembly lines.

10. A low stress wafer mounting method according claim 9 wherein the precut tapes (2) are provided from a cutting tool with a diameter greater than that of the diced wafer (3).
